# EUROPEAN PATENT SPECIFICATION

(11) **EP 4 628 915 B1**
(45) Date of publication and mention of the grant of the patent: **25.11.2026**
(21) Application number: 23912842.4
(22) Date of filing: 22.12.2023
(51) Int. Cl.: G01R 31/367, G01R 31/392, G01R 31/3828, G01R 31/3842, B60L 3/00, B60L 3/12, B60L 58/16, H01M 10/42, H01M 10/48

(54) **BATTERY MANAGEMENT APPARATUS AND METHOD**
VORRICHTUNG UND VERFAHREN ZUR VERWALTUNG EINER BATTERIE
APPAREIL ET PROCÉDÉ DE GESTION DE BATTERIE

(30) Priority: 26.12.2022 KR 20220185033; 12.09.2023 KR 20230121412
(43) Date of publication of application: 08.10.2025
(73) Proprietor: LG Energy Solution, Ltd., Seoul 07335 (KR)
(72) Inventor: YOON, Seo-Young, Daejeon 34122 (KR); CHOI, Soon-Hyung, Daejeon 34122 (KR)
(74) Representative: Goddar, Heinz J.
(86) International application number: PCT/KR2023/021508
(87) International publication number: WO 2024/144167

(56) References cited:
- EP-A1- 4 131 571
- EP-A1- 4 148 441
- EP-A1- 4 468 004
- EP-A1- 4 553 523
- EP-A2- 4 556 925
- WO-A1-2022/035032
- WO-A1-2022/035130
- KR-A- 20120 029 735
- KR-A- 20150 048 439
- KR-A- 20170 022 746
- KR-A- 20180 057 202
- KR-A- 20220 021 730

## Description

### TECHNICAL FIELD

The present application claims priority to Korean Patent Application No. 10-2022-0185033 filed on December 26, 2022 in the Republic of Korea and Korean Patent Application No. 10-2023-0121412 filed on September 12, 2023 in the Republic of Korea.

The present disclosure relates to a battery management apparatus and method, and more particularly, to a battery management apparatus and method for estimating a positive electrode profile and a negative electrode profile for a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

A lot of research is being done on these batteries in terms of increasing capacity and density, but improving lifespan and safety is also important. In order to improve battery safety, the current state of the battery must be accurately diagnosed.

In order to most accurately diagnose the current state of the battery, the positive electrode profile and negative electrode profile of the battery must be secured and analyzed separately. However, since disassembly and assembly of the manufactured battery are virtually impossible, there is a problem that it is impossible to directly measure the positive electrode profile and negative electrode profile of the manufactured battery. Therefore, in order to more accurately diagnose the state of the battery, technology is required to accurately estimate the positive electrode profile and negative electrode profile corresponding to the battery.

WO 2022/035032 A1 discloses a battery management device and method capable of obtaining a positive electrode profile and a negative electrode profile for a battery cell in a non-destructive manner by appropriately adjusting a preconfigured negative electrode profile. According to an aspect of the disclosure, an adjusted negative electrode profile and a battery profile for a degraded battery cell are used, so that a positive electrode profile of a degraded battery cell can be easily estimated in a non-destructive manner.

### DISCLOSURE

### Technical Problem

The present disclosure is designed to solve the problems of the related art, and therefore the present disclosure is directed to providing a battery management apparatus and method capable of accurately estimating a positive electrode profile and a negative electrode profile corresponding to a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

The invention is set out in the appended claims. A battery management apparatus according to one aspect of the present disclosure comprises:
a profile obtaining unit configured to obtain a measurement full-cell profile representing the corresponding relationship between voltage and capacity of a battery; a profile determining unit configured to divide the measurement full-cell profile into a plurality of sections according to a predetermined criterion, adjust a preset reference positive electrode profile and a reference negative electrode profile to correspond to the measurement full-cell profile based on a weight for each of the plurality of sections, and generate an adjustment positive electrode profile and an adjustment negative electrode profile according to the adjustment result; and a control unit configured to determine a diagnostic factor for the battery from at least one of the adjustment positive electrode profile and the adjustment negative electrode profile.

The profile obtaining unit may be configured to further obtain a full-cell differential profile corresponding to the measurement full-cell profile and representing the corresponding relationship between capacity and differential voltage.

The profile determining unit may be configured to divide the measurement full-cell profile into the plurality of sections based on at least one of a plurality of peaks included in the full-cell differential profile.

The profile determining unit may be configured to divide the measurement full-cell profile into the plurality of sections based on a plurality of reference peaks included in the full-cell differential profile.

The profile determining unit may be configured to set a weight for each of the plurality of sections and adjust the reference positive electrode profile and the reference negative electrode profile to correspond to the measurement full-cell profile based on the weight.

The profile determining unit may be configured to set a weight for a target section containing at least one of a plurality of target peaks included in the full-cell differential profile to be larger than weights for the remaining sections.

The profile determining unit may be configured to generate a comparison full-cell profile based on the adjustment positive electrode profile and the adjustment negative electrode profile, and adjust the reference positive electrode profile and the reference negative electrode profile so that a section where the set weight is larger has a lower error rate between the comparison full-cell profile and the measurement full-cell profile.

The control unit may be configured to determine a positive electrode factor included in the diagnostic factor based on the adjustment positive electrode profile and determine a negative electrode factor included in the diagnostic factor based on the adjustment negative electrode profile.

A battery pack according to another aspect of the present disclosure comprises the battery management apparatus according to an aspect of the present disclosure.

A vehicle according to still another aspect of the present disclosure comprises the battery management apparatus according to an aspect of the present disclosure.

A battery management method according to still another aspect of the present disclosure comprises:
a profile obtaining step of obtaining a measurement full-cell profile representing the corresponding relationship between voltage and capacity of a battery; a profile adjusting step of dividing the measurement full-cell profile into a plurality of sections according to a predetermined criterion and adjusting a preset reference positive electrode profile and a reference negative electrode profile to correspond to the measurement full-cell profile based on a weight for each of the plurality of sections; a profile generating step of generating an adjustment positive electrode profile and an adjustment negative electrode profile according to the adjustment result; and a factor determining step of determining a diagnostic factor for the battery from at least one of the adjustment positive electrode profile and the adjustment negative electrode profile.

### Advantageous Effects

According to one aspect of the present disclosure, the battery management apparatus has the advantage of being able to estimate the positive electrode profile and negative electrode profile of a battery that cannot be directly measured by adjusting the reference positive electrode profile and reference negative electrode profile.

Additionally, since the battery management apparatus may determine a diagnostic factor that represents the current state of the battery, the current state of the battery may be diagnosed based on the diagnostic factor. In other words, the battery management apparatus has the advantage of being able to determine diagnostic factors that can diagnose the current state of the battery in a non-destructive manner.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a battery management apparatus according to an embodiment of the present disclosure.
FIG. 2 is a diagram showing a measurement full-cell profile according to an embodiment of the present disclosure.
FIG. 3 is a diagram showing a reference positive electrode profile, a reference negative electrode profile, and a reference full-cell profile according to an embodiment of the present disclosure.
FIG. 4 is a diagram showing the measurement full-cell profile and the reference full-cell profile according to an embodiment of the present disclosure.
FIG. 5 is a diagram showing the reference full-cell profile and a comparison full-cell profile according to an embodiment of the present disclosure.
FIG. 6 is a diagram showing a full-cell differential profile according to an embodiment of the present disclosure.
FIG. 7 is a diagram showing a full-cell differential profile according to an embodiment of the present disclosure.
FIG. 8 is a diagram showing the measurement full-cell profile and a plurality of sections according to an embodiment of the present disclosure.
FIG. 9 is a diagram showing the measurement full-cell profile and a first comparison full-cell profile according to an embodiment of the present disclosure.
FIG. 10 is a diagram showing the measurement full-cell profile and a plurality of sections according to an embodiment of the present disclosure.
FIG. 11 is a diagram showing the measurement full-cell profile and a second comparison full-cell profile according to an embodiment of the present disclosure.
FIG. 12 is a diagram showing a positive electrode differential profile according to an embodiment of the present disclosure.
FIG. 13 is a diagram showing a negative electrode differential profile according to an embodiment of the present disclosure.
FIG. 14 is a diagram showing a reference positive electrode profile and a reference negative electrode profile according to an embodiment of the present disclosure.
FIG. 15 is a diagram showing the measurement full-cell profile and a third comparison full-cell profile according to an embodiment of the present disclosure.
FIG. 16 is a diagram schematically showing an exemplary configuration of a battery pack according to another embodiment of the present disclosure.
FIG. 17 is a diagram schematically showing a vehicle according to still another embodiment of the present disclosure.
FIG. 18 is a diagram schematically showing a battery management method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

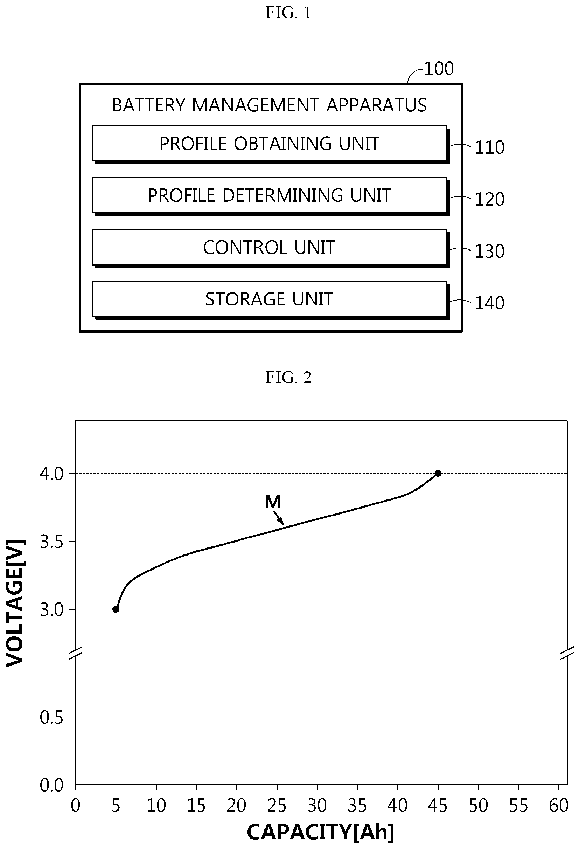

FIG. 1 is a diagram schematically showing a battery management apparatus 100 according to an embodiment of the present disclosure.

Referring to FIG. 1, the battery management apparatus 100 may include a profile obtaining unit 110, a profile determining unit 120, and a control unit 130.

Here, the battery means one physically separable independent cell including a negative electrode terminal and a positive electrode terminal. For example, one lithium-ion battery or lithium polymer battery may be regarded as a battery. Additionally, the type of battery may be cylindrical type, prismatic type, or pouch type. Additionally, the battery may mean a battery bank, battery module, or battery pack in which a plurality of cells are connected in series and/or parallel. Hereinafter, for convenience of explanation, the battery is explained as meaning one independent cell.

The profile obtaining unit 110 may be configured to obtain a measurement full-cell profile M representing the corresponding relationship between voltage and capacity of a battery.

Specifically, the measurement full-cell profile M is a profile that represents the corresponding relationship between voltage (V) and capacity (Q) when the SOC of the battery is charged from 0% to 100%.

For example, there is no special limitation on the C-rate in charging or discharging to generate the measurement full-cell profile M. However, preferably, in order to obtain the measurement full-cell profile M and the full-cell differential profile D more accurately, the battery should be charged or discharged at a low rate. For example, in the process of charging or discharging a battery at 0.05 C, the measurement full-cell profile M may be generated.

For example, the profile obtaining unit 110 may directly receive the measurement full-cell profile M of the battery from the outside. That is, the profile obtaining unit 110 may obtain the measurement full-cell profile M by receiving the measurement full-cell profile M by being connected to the outside by wire and/or wirelessly.

As another example, the profile obtaining unit 110 may receive battery information about the voltage and capacity of the battery. Also, the profile obtaining unit 110 may obtain the measurement full-cell profile M by generating the measurement full-cell profile M based on the received battery information.

FIG. 2 is a diagram showing a measurement full-cell profile M according to an embodiment of the present disclosure.

For example, in the embodiment of FIG. 2, the measurement full-cell profile M may be expressed as a two-dimensional X-Y graph with the X-axis set to capacity [Ah] and the Y-axis set to voltage [V].

The profile obtaining unit 110 may be connected to communicate with the control unit 130. For example, the profile obtaining unit 110 may be connected to the control unit 130 by wire and/or wirelessly. The profile obtaining unit 110 may transmit the obtained measurement full-cell profile M to the profile determining unit 120.

The profile determining unit 120 may be configured to divide the measurement full-cell profile M into a plurality of sections according to a predetermined criterion.

Specifically, the profile determining unit 120 may divide the measurement full-cell profile M into a plurality of sections according to a predetermined capacity criterion.

For example, the profile determining unit 120 may divide the entire capacity section of the measurement full-cell profile M into a plurality of sections based on the capacity value determined according to the predetermined capacity criterion.

The profile determining unit 120 may be configured to adjust a preset reference positive electrode profile Rp and reference negative electrode profile Rn to correspond to the measurement full-cell profile M, based on the weight for each of the plurality of sections.

Here, the reference positive electrode profile Rp may be a profile representing the corresponding relationship between the capacity and voltage of a preset reference positive electrode cell to correspond to the positive electrode of the battery. For example, the reference positive electrode cell may be the positive electrode of a positive electrode coin half-cell or a three-electrode cell. Additionally, the reference negative electrode profile Rn may be a profile representing the corresponding relationship between the capacity and voltage of a preset reference negative electrode cell to correspond to the negative electrode of the battery. For example, the reference negative electrode cell may be the negative electrode of a negative electrode coin half-cell or a three-electrode cell.

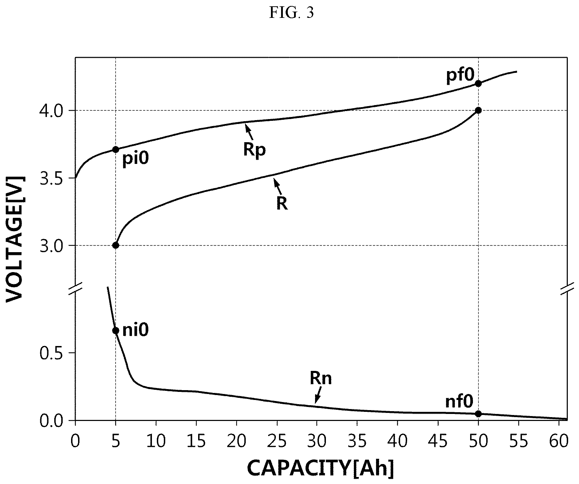

FIG. 3 is a diagram showing a reference positive electrode profile Rp, a reference negative electrode profile Rn, and a reference full-cell profile R according to an embodiment of the present disclosure.

In the embodiment of FIG. 3, in the reference positive electrode profile Rp, the positive electrode participation start point is pi0, and the positive electrode participation end point is pf0. In the reference negative electrode profile Rn, the negative electrode participation start point is ni0, and the negative electrode participation end point is nf0. The reference full-cell profile R may be expressed as the difference between the positive electrode potential of the reference positive electrode profile Rp and the negative electrode potential of the reference negative electrode profile Rn as a criterion for the same capacity.

Specifically, depending on whether the measurement full-cell profile M is divided, the adjustment target of the reference positive electrode profile Rp and the reference negative electrode profile Rn may be different as the entire section of the measurement full-cell profile M or each section of the measurement full-cell profile M.

For example, if the measurement full-cell profile M is divided into a plurality of sections, the profile determining unit 120 may adjust the reference positive electrode profile Rp and the reference negative electrode profile Rn by considering the weight of each section of the measurement full-cell profile M. Specifically, the profile determining unit 120 may adjust the reference positive electrode profile Rp and the reference negative electrode profile Rn so that as a weight set for a section is larger, the error of the corresponding section with respect to the measurement full-cell profile M is lower.

Specifically, the profile determining unit 120 may generate a plurality of comparison full-cell profile S by shifting or capacity scaling of the reference positive electrode profile Rp and reference negative electrode profile Rn, and specify the comparison full-cell profile S with a minimum error among the plurality of comparison full-cell profiles S for each section of the measurement full-cell profile M. Here, the comparison full-cell profile S calculated with a smaller error may be specified as the weight set in the section increases. Additionally, the profile determining unit 120 may determine the adjustment positive electrode profile Rp' and the adjustment negative electrode profile Rn' corresponding to the specified comparison full-cell profile S.

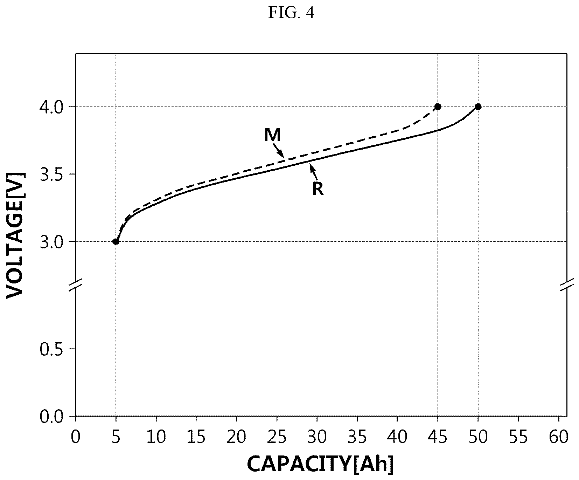

FIG. 4 is a diagram showing the measurement full-cell profile M and the reference full-cell profile R according to an embodiment of the present disclosure.

In the embodiment of FIG. 4, the reference full-cell profile R and the measurement full-cell profile M may be different so that they do not correspond to each other. For example, the voltage section of the measurement full-cell profile M and the reference full-cell profile R are the same as 3.0 [V] to 4.0 [V], but the capacity section of the measurement full-cell profile M is 5 [Ah] to 45 [Ah], but the capacity section of the reference full-cell profile R may be 5 [Ah] to 50 [Ah]. Since the reference full-cell profile R and the measurement full-cell profile M are different from each other, the profile determining unit 120 may adjust the reference positive electrode profile Rp and reference negative electrode profile Rn to correspond to the measurement full-cell profile M.

The profile determining unit 120 may be configured to generate an adjustment positive electrode profile Rp' and an adjustment negative electrode profile Rn' according to the adjustment result.

Specifically, the adjustment positive electrode profile Rp' is the result of adjusting the reference positive electrode profile Rp, and the adjustment negative electrode profile Rn' is the result of adjusting the reference negative electrode profile Rn. In other words, the comparison full-cell profile S is specified according to the adjustment results of the reference positive electrode profile Rp and the reference negative electrode profile Rn, and the basis of the comparison full-cell profile S is the adjustment positive electrode profile Rp' and the adjustment negative electrode profile Rn'. Therefore, the adjustment positive electrode profile Rp' and the adjustment negative electrode profile Rn' may be strongly estimated as the positive electrode profile and the negative electrode profile of the battery.

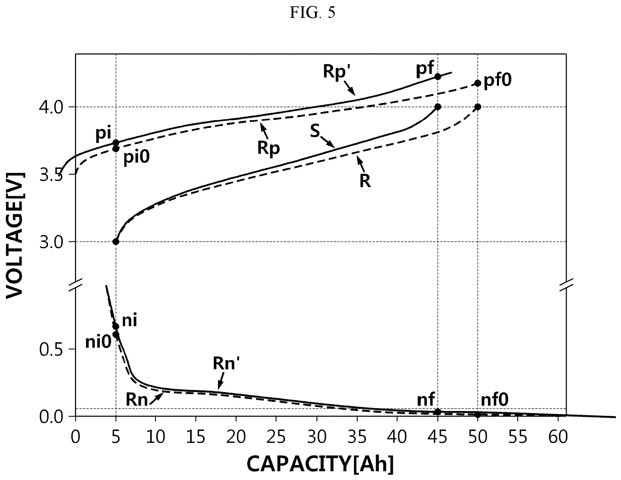

FIG. 5 is a diagram showing the reference full-cell profile R and a comparison full-cell profile S according to an embodiment of the present disclosure.

For example, in the embodiment of FIG. 5, the reference positive electrode profile Rp may be adjusted to the adjustment positive electrode profile Rp', and the reference negative electrode profile Rn may be adjusted to the adjustment negative electrode profile Rn'. That is, the reference full-cell profile R may be adjusted to the comparison full-cell profile S. Specifically, the positive electrode participation start point pi0 of the reference positive electrode profile Rp may be adjusted to the positive electrode participation start point pi of the adjustment positive electrode profile Rp', and the positive electrode participation end point pf0 of the reference positive electrode profile Rp may be adjusted to the positive electrode participation end point pf of the adjustment positive electrode profile Rp'. The negative electrode participation start point ni0 of the reference negative electrode profile Rn may be adjusted to the negative electrode participation start point ni of the adjustment negative electrode profile Rn', and the negative electrode participation end point nf0 of the reference negative electrode profile Rn may be adjusted to the negative electrode participation end point nf of the adjustment negative electrode profile Rn'.

The control unit 130 may be configured to determine a diagnostic factor for the battery from at least one of the adjustment positive electrode profile Rp' and the adjustment negative electrode profile Rn'.

Specifically, the diagnostic factor may include at least one of a positive electrode factor and a negative electrode factor. That is, the control unit 130 may be configured to determine the positive electrode factor for the battery based on the adjustment positive electrode profile Rp'. Additionally, the control unit 130 may be configured to determine the negative electrode factor for the battery based on the adjustment negative electrode profile Rn'.

For example, the positive electrode factor may include the positive electrode participation start point pi, the positive electrode participation end point pf, and the positive electrode change rate ps.

The positive electrode participation start point pi is the start point of the adjustment positive electrode profile Rp'. For example, in the embodiment of FIG. 5, the positive electrode participation start point pi is a point corresponding to capacity 5 [Ah] in the adjustment positive electrode profile Rp'.

The positive electrode participation end point pf is the end point of the adjustment positive electrode profile Rp'. For example, in the embodiment of FIG. 5, the positive electrode participation end point pf is a point corresponding to capacity 45 [Ah] in the adjustment positive electrode profile Rp'.

The positive electrode change rate ps may mean the change rate [%] of the adjustment positive electrode profile Rp' with respect to the reference positive electrode profile Rp. Specifically, the positive electrode change rate ps may be the contraction ratio or expansion ratio of the adjustment positive electrode profile Rp' with respect to the reference positive electrode profile Rp. For example, if the adjustment positive electrode profile Rp' is 10% shrinkage from the reference positive electrode profile Rp, the positive electrode change rate ps is 90%. Conversely, if the adjustment positive electrode profile Rp' is expanded by 10% from the reference positive electrode profile Rp, the positive electrode change rate ps is 110%.

As another example, the negative electrode factor may include the negative electrode participation start point ni, the negative electrode participation end point nf, and the negative electrode change rate ns.

The negative electrode participation start point ni is the start point of the adjustment negative electrode profile Rn'. For example, in the embodiment of FIG. 5, the negative electrode participation start point ni is a point corresponding to capacity 5 [Ah] in the adjustment negative electrode profile Rn'.

The negative electrode participation end point nf is the end point of the adjustment negative electrode profile Rn'. For example, in the embodiment of FIG. 5, the negative electrode participation end point nf is a point corresponding to capacity 45 [Ah] in the adjustment negative electrode profile Rn'.

The negative electrode change rate ns may mean the change rate [%] of the adjustment negative electrode profile Rn' with respect to the reference negative electrode profile Rn. Specifically, the negative electrode change rate ns may be the contraction ratio or expansion ratio of the adjustment negative electrode profile Rn' with respect to the reference negative electrode profile Rn. For example, if the adjustment negative electrode profile Rn' is 10% shrinkage from the reference negative electrode profile Rn, the negative electrode change rate ns is 90%. Conversely, if the adjustment negative electrode profile Rn' is expanded by 10% from the reference negative electrode profile Rn, the negative electrode change rate ns is 110%.

The battery management apparatus 100 according to an embodiment of the present disclosure has the advantage of being able to estimate the positive electrode profile and negative electrode profile of a battery that cannot be directly measured by adjusting the reference positive electrode profile Rp and the reference negative electrode profile Rn. Additionally, since the battery management apparatus 100 may determine a diagnostic factor representing the current state of the battery, the current state of the battery may be diagnosed based on the diagnostic factor. In other words, the battery management apparatus 100 has the advantage of being able to determine diagnostic factors that can diagnose the current state of the battery in a non-destructive manner.

For example, it is assumed that the control unit 130 determines the positive electrode change rate ps as a diagnostic factor. The control unit 130 may compare the determined positive electrode change rate ps with a criterion rate preset for the battery. Additionally, the control unit 130 may diagnose the state of the battery based on the ratio difference between the positive electrode change rate ps and the criterion rate. If the calculated ratio difference is greater than or equal to a threshold value, the control unit 130 may diagnose the state of the battery as an abnormal state or a deteriorated state. Conversely, if the ratio difference is less than the threshold value, the control unit 130 may diagnose the state of the battery as a normal state.

As another example, it is assumed that the control unit 130 determines the positive electrode change rate ps for the plurality of batteries as a diagnosis factor. The control unit 130 may diagnose the relative degree of degradation for the plurality of batteries by comparing the magnitude of the determined plurality of positive electrode change rates ps. For example, the control unit 130 may diagnose that the larger the determined positive electrode change rate ps, the more deteriorated the battery.

In the above, an embodiment in which the control unit 130 diagnoses the state of the battery using the positive electrode change rate ps has been described, but note that the state of the battery may be diagnosed based on at least one of the diagnostic factors.

Additionally, the control unit 130 may diagnose the state of the battery by combining diagnosis results for a plurality of diagnostic factors. For example, the control unit 130 may diagnose the state of the battery based on the majority of diagnosis results among the plurality of diagnostic factors.

Meanwhile, the control unit 130 provided in the battery management apparatus 100 may selectively include processors known in the art, application-specific integrated circuits (ASICs), other chipsets, logic circuits, registers, communication modems, data processing devices, and the like to execute various control logic performed in the present disclosure. Also, when the control logic is implemented in software, the control unit 130 may be implemented as a set of program modules. At this time, the program module may be stored in a memory and executed by the control unit 130. The memory may be located inside or out of the control unit 130 and may be connected to the control unit 130 by various well-known means.

In addition, the battery management apparatus 100 may further include a storage unit 140. The storage unit 140 may store data necessary for operation and function of each component of the battery management apparatus 100, data generated in the process of performing the operation or function, or the like. The storage unit 140 is not particularly limited in its type as long as it is a known information storage means that can record, erase, update and read data. As an example, the information storage means may include RAM, flash memory, ROM, EEPROM, registers, and the like. In addition, the storage unit 140 may store program codes in which processes executable by the control unit 130 are defined.

For example, the storage unit 140 may store the reference positive electrode profile Rp, the reference negative electrode profile Rn, the reference full-cell profile R, the measurement full-cell profile M, the adjustment positive electrode profile Rp', the adjustment negative electrode profile Rn', the comparison full-cell profile S, the positive electrode factor, the negative electrode factor, etc.

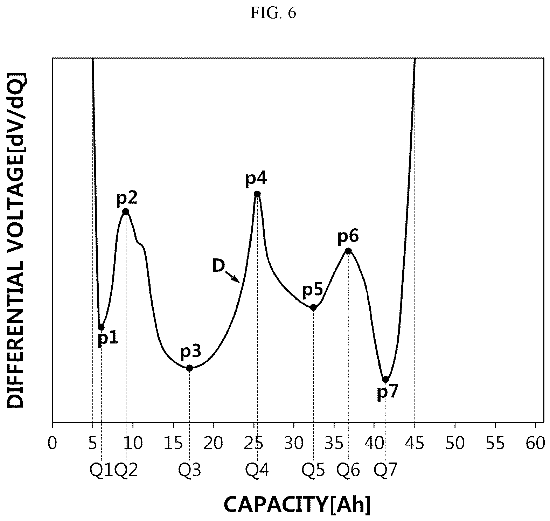

Hereinafter, with reference to FIGS. 6 to 9, a first embodiment in which the profile determining unit 120 adjusts the reference positive electrode profile Rp and the reference negative electrode profile Rn will be described in detail.

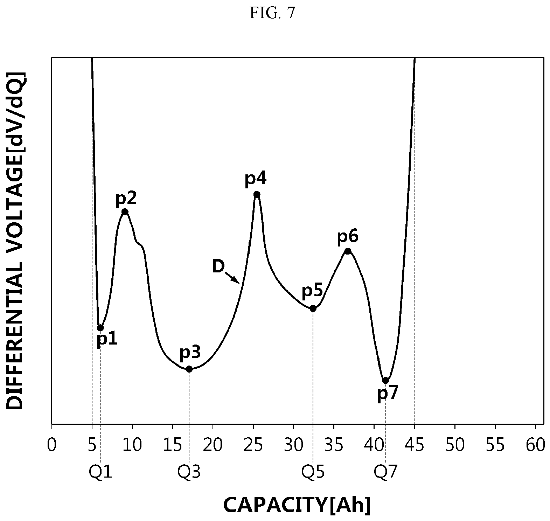

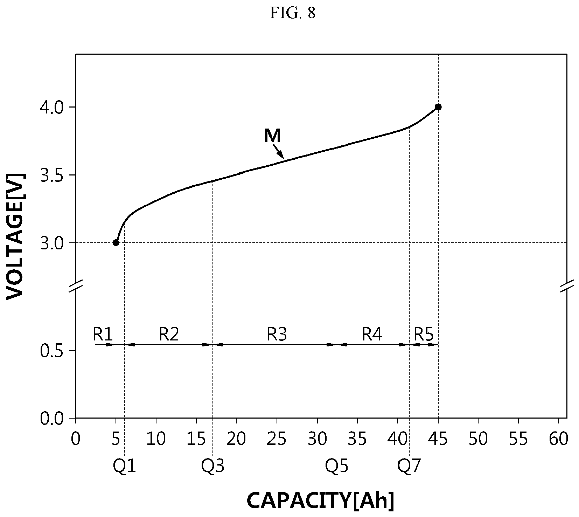

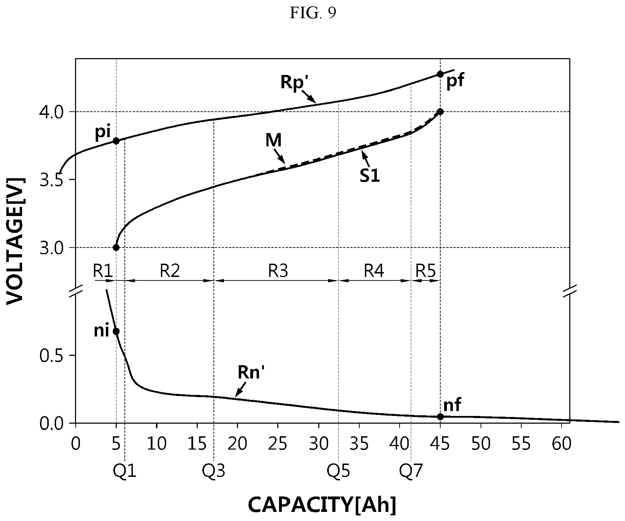

Specifically, FIGS. 6 and 7 are diagrams showing a full-cell differential profile D according to an embodiment of the present disclosure. FIG. 8 is a diagram showing the measurement full-cell profile M and a plurality of sections R1 to R5 according to an embodiment of the present disclosure. FIG. 9 is a diagram showing the measurement full-cell profile M and a first comparison full-cell profile S1 according to an embodiment of the present disclosure.

The profile obtaining unit 110 may be configured to further obtain a full-cell differential profile D that corresponds to the measurement full-cell profile M and represents the corresponding relationship between capacity and differential voltage.

Specifically, the full-cell differential profile D is a profile obtained by differentiating the measurement full-cell profile M with respect to capacity. In other words, the full-cell differential profile D is a profile that represents the corresponding relationship between capacity and differential voltage. Here, the differential voltage is a value obtained by differentiating voltage (V) with respect to capacity (Q), and may be expressed as "dV/dQ."

For example, in the embodiment of FIG. 6, the full-cell differential profile D may be expressed as a two-dimensional X-Y graph with the X-axis set to capacity [Ah] and the Y-axis set to differential voltage [dV/dQ].

For example, the profile obtaining unit 110 may directly receive the full-cell differential profile D of the battery from the outside. That is, the profile obtaining unit 110 may obtain the full-cell differential profile D by receiving the full-cell differential profile D by being connected to an external by wire and/or wirelessly.

As another example, the profile obtaining unit 110 may generate a full-cell differential profile D based on the received measurement full-cell profile M or the directly generated measurement full-cell profile M. That is, the profile obtaining unit 110 may obtain the full-cell differential profile D by directly generating the full-cell differential profile D by differentiating the measurement full-cell profile M with respect to capacity.

The profile obtaining unit 110 may transmit the obtained full-cell differential profile D to the profile determining unit 120.

The profile determining unit 120 may be configured to divide the measurement full-cell profile M into a plurality of sections based on at least one of the plurality of peaks included in the full-cell differential profile D.

Specifically, the peak refers to a point corresponding to the inflection point of the measurement full-cell profile M. In other words, the peak refers to a point in the full-cell differential profile D where the instantaneous change rate of differential voltage to capacity is 0. For example, the maximum point and minimum point of the full-cell differential profile D may be determined as the peak.

For example, in the embodiment of FIG. 6, the profile determining unit 120 may determine the first to seventh peaks p1 to p7 in the full-cell differential profile D. Here, the first peak p1, the third peak p3, the fifth peak p5, and the seventh peak p7 are peaks corresponding to the minimum point of the full-cell differential profile D, and the second peak p2, the fourth peak p4, and the sixth peak p6 are peaks corresponding to the maximum point of the full-cell differential profile D.

The profile determining unit 120 may be configured to divide the measurement full-cell profile M into a plurality of sections R1 to R5 based on the plurality of reference peaks included in the full-cell differential profile D.

Specifically, the reference peak is a peak corresponding to the minimum point of the full-cell differential profile D. For example, in the embodiment of FIG. 7, the plurality of reference peaks may include a first peak p1, a third peak p3, a fifth peak p5, and a seventh peak p7.

In the embodiment of FIG. 8, the profile determining unit 120 may divide the full-cell profile M into first to fifth sections R1 to R5 according to the plurality of capacities Q1, Q3, Q5, and Q7 corresponding to the reference peaks p1, p3, p5, and p7. Here, the first section R1 is the capacity section of 0 [Ah] to Q1, the second section R2 is the capacity section of Q1 to Q3, and the third section R3 is the capacity section of Q3 to Q5. The fourth section R4 is the capacity section of Q5 to Q7, and the fifth section R5 is the capacity section of Q7 to 45 [Ah].

The profile determining unit 120 may be configured to set a weight for each of the plurality of sections R1 to R5.

Here, the weight set for each of the plurality of sections R1 to R5 is a value between 0 and 1, and the total sum of the set weights is 1.

For example, the control unit 130 may set the weights of the first to fifth sections R1 to R5 by 0.2.

As another example, the control unit 130 may set the weights of the first to fifth sections R1 to R5 according to the importance of the first to fifth sections R1 to R5. Specifically, among the plurality of sections R1 to R5, some are sections that reflect the state of the positive electrode of the battery, and others are sections that reflect the state of the negative electrode of the battery. Accordingly, the control unit 130 may set the importance of the section corresponding to the item to be diagnosed among the plurality of sections R1 to R5 high. Also, the weight for a section with high importance may be set to be larger than the weight for other sections.

Specifically, the profile determining unit 120 may be configured to set the weight for the target section including at least one of the plurality of target peaks included in the full-cell differential profile D to be larger than the weight for the remaining sections.

Specifically, the target peak is a peak corresponding to the maximum point of the full-cell differential profile D. For example, in the embodiment of FIG. 7, the plurality of target peaks may include a second peak p2, a fourth peak p4, and a sixth peak p6.

The control unit 130 may select at least one of the plurality of target peaks according to the diagnosis target and determine the section including the selected target peak as the target section. For example, if the diagnosis item is the state of the negative electrode, the control unit 130 may determine the second section R2, which includes the second peak p2, as the target section, and set the weight for the second section R2 to be the largest. As another example, if the diagnosis item is the state of a positive electrode, the control unit 130 may determine the fourth section R4, which includes the sixth peak p6, as the target section, and set the weight for the fourth section R4 to be the largest.

The profile determining unit 120 may be configured to adjust the reference positive electrode profile Rp and the reference negative electrode profile Rn to correspond to the measurement full-cell profile M based on the weight.

Specifically, the profile determining unit 120 may be configured to generate a first comparison full-cell profile S1 based on the adjustment positive electrode profile Rp' and the adjustment negative electrode profile Rn'.

For example, the profile determining unit 120 may generate a plurality of comparison full-cell profiles by shifting or capacity scaling of the reference positive electrode profile Rp and the reference negative electrode profile Rn. In the embodiment of FIG. 9, the profile determining unit 120 may determine the first comparison full-cell profile S1 corresponding to the measurement full-cell profile M based on the adjustment positive electrode profile Rp' and the adjustment negative electrode profile Rn'. The control unit 130 may determine the positive electrode participation start point of the battery as pi and the positive electrode participation end point as pf. Additionally, the control unit 130 may determine the negative electrode participation start point of the battery as ni and the negative electrode participation end point as nf.

Additionally, the profile determining unit 120 may be configured to adjust the reference positive electrode profile Rp and the reference negative electrode profile Rn so that the error rate between the comparison full-cell profile S and the measurement full-cell profile M decreases as the set weight of the section is larger.

For example, the profile determining unit 120 may specify a comparison full-cell profile with a low error rate in the order of the largest weight among the plurality of sections R1 to R5 of the measurement full-cell profile M among the plurality of comparison full-cell profiles. Assuming that 100 comparison full-cell profiles have been generated and the target section is the second section R2, the profile determining unit 120 may specify the first comparison full-cell profile S1 with the lowest error rate in the second section R2 among the 100 comparison full-cell profiles. Additionally, the profile determining unit 120 may determine the adjustment positive electrode profile Rp' and the adjustment negative electrode profile Rn' corresponding to the specified first comparison full-cell profile S1. If there are multiple comparison full-cell profiles with the lowest error rate in the second section R2, the profile determining unit 120 may specify the first comparison full-cell profile S1 with the lower overall error rate for the entire capacity section of the measurement full-cell profile M.

The battery management apparatus 100 according to an embodiment of the present disclosure has the advantage of being able to determine a diagnostic factor that better reflects the state of the battery because it adjusts the reference positive electrode profile Rp and the reference negative electrode profile Rn to correspond to the diagnostic item. In other words, because the optimal diagnostic factor corresponding to the diagnostic item may be determined, the state of the battery may be diagnosed more accurately.

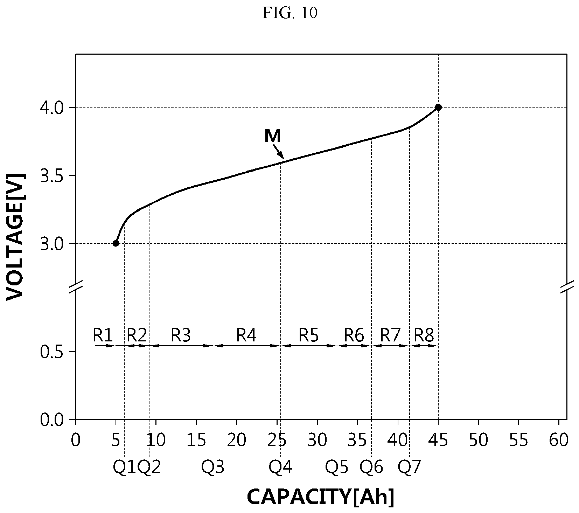

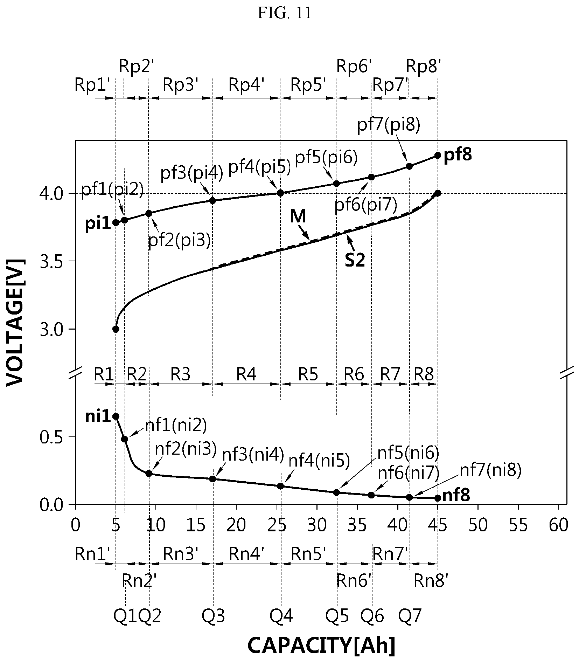

Hereinafter, with reference to FIGS. 10 and 11, a second embodiment in which the profile determining unit 120 adjusts the reference positive electrode profile Rp and the reference negative electrode profile Rn will be described in detail.

Specifically, FIG. 10 is a diagram showing the measurement full-cell profile M and a plurality of sections according to an embodiment of the present disclosure. FIG. 11 is a diagram showing the measurement full-cell profile M and a second comparison full-cell profile S2 according to an embodiment of the present disclosure.

Specifically, the profile determining unit 120 may be configured to divide the measurement full-cell profile M into a plurality of sections based on the capacities of the plurality of peaks included in the full-cell differential profile D.

For example, referring to FIGS. 6 and 10, the profile determining unit 120 may divide the measurement full-cell profile M into first to eighth sections R1 to R8 according to the plurality of capacities Q1 to Q7 corresponding to the first to seventh peaks p1 to p7. Here, the first section R1 is the capacity section of 0 [Ah] to Q1, the second section R2 is the capacity section of Q1 to Q2, and the third section R3 is the capacity section of Q2 to Q3. The fourth section R4 is the capacity section of Q3 to Q4, the fifth section R5 is the capacity section of Q4 to Q5, and the sixth section R6 is the capacity section of Q5 to Q6. The seventh section R7 is the capacity section of Q6 to Q7, and the eighth section R8 is the capacity section of Q7 to 45 [Ah].

Additionally, the profile determining unit 120 may be configured to adjust the reference positive electrode profile Rp and reference negative electrode profile Rn to correspond to each of the plurality of sections. That is, the profile determining unit 120 may be configured to generate an adjustment positive electrode profile and an adjustment negative electrode profile corresponding to each of the plurality of sections.

Specifically, the reference positive electrode profile Rp and reference negative electrode profile Rn may be adjusted to correspond to each section of the measurement full-cell profile M.

For example, in the embodiment of FIG. 10, the profile determining unit 120 may adjust the reference positive electrode profile Rp and the reference negative electrode profile Rn with respect to the first section R1 of the measurement full-cell profile M. Specifically, among the plurality of comparison full-cell profiles generated by the profile determining unit 120, the comparison full-cell profile that is most similar to the measurement full-cell profile M (e.g., has a small error) in the first section R1may be specified. Additionally, the profile determining unit 120 may determine the first adjustment positive electrode profile Rp1' and the first adjustment negative electrode profile Rn1' corresponding to the specified comparison full-cell profile.

In the same manner, the profile determining unit 120 may determine second to eighth adjustment positive electrode profiles Rp2' to Rp8' and second to eighth adjustment negative electrode profiles Rn2' to Rn8' for each of the second to eighth sections R2 to R8 of the measurement full-cell profile M.

For example, in the embodiment of FIG. 11, the first adjustment positive electrode profile Rp1' and the first adjustment negative electrode profile Rn1' corresponding to the first section R1 may be determined, and the second adjustment positive electrode profile Rp2' and the second adjustment negative electrode profile Rn2' corresponding to the second section R2 may be determined. The third adjustment positive electrode profile Rp3' and the third adjustment negative electrode profile Rn3' corresponding to the third section R3 may be determined, and the fourth adjustment positive electrode profile Rp4' and the fourth adjustment negative electrode profile Rn4' corresponding to the fourth section R4 may be determined. The fifth adjustment positive electrode profile Rp5' and the fifth adjustment negative electrode profile Rn5' corresponding to the fifth section R5 may be determined, and the sixth adjustment positive electrode profile Rp6' and the sixth adjustment negative electrode profile Rn6' corresponding to the sixth section R6 may be determined. The seventh adjustment positive electrode profile Rp7' and the seventh adjustment negative electrode profile Rn7' corresponding to the seventh section R7 may be determined, and the eighth adjustment positive electrode profile Rp8' and the eighth adjustment negative electrode profile Rn8' corresponding to the eighth section R8 may be determined.

The control unit 130 may determine the positive electrode factor from each of the plurality of adjustment positive electrode profiles Rp1' to Rp8' and determine the negative electrode factor from each of the plurality of adjustment negative electrode profiles Rn1' to Rn8'. Additionally, the control unit 130 may diagnose the positive electrode state of the battery in the corresponding section based on each of the determined plurality of positive electrode factors. Additionally, the control unit 130 may diagnose the negative electrode state of the battery in the corresponding section based on each of the determined plurality of negative electrode factors.

In the embodiment of FIG. 11, the control unit 130 may determine the positive electrode participation start points pi1 to pi8, the positive electrode participation end points pf1 to pf8, and the positive electrode change rates ps1 to ps8 of the first to eighth adjustment positive electrode profiles Rp1' to Rp8'. Likewise, the control unit 130 may determine the negative electrode participation start points ni1 to ni8, the negative electrode participation end points nf1 to nf8, and the negative electrode change rates ns1 to ns8 of the first to eighth adjustment negative electrode profiles Rn1' to Rn8'.

For example, the control unit 130 may determine the degree of positive electrode degradation of each of the first to eighth sections R1 to R8 by considering the plurality of positive electrode change rates ps1 to ps8. Specifically, the control unit 130 may determine the positive electrode change rate of each of the first to eighth sections R1 to R8 as the degree of positive electrode degradation in the corresponding section. Accordingly, the control unit 130 may determine the section in which the positive electrode is most degenerated among the first to eighth sections R1 to R8.

As another example, the control unit 130 may determine the degree of negative electrode degradation of each of the first to eighth sections R1 to R8 by considering the plurality of negative electrode change rates ns1 to ns8. Specifically, the control unit 130 may determine the negative electrode change rate for each of the first to eighth sections R1 to R8 as the degree of negative electrode degradation in the corresponding section. Accordingly, the control unit 130 may determine the section in which the negative electrode is most degraded among the first to eighth sections R1 to R8.

In the embodiment of FIG. 11, the profile determining unit 120 may determine the first comparison full-cell profile S1 corresponding to the measurement full-cell profile M based on the first to eighth adjustment positive electrode profiles Rp1' to Rp8' and the first to eighth adjustment negative electrode profiles Rn1' to Rn8'. The control unit 130 may determine the positive electrode participation start point of the battery as pi1 and determine the positive electrode participation end point as pf8. Additionally, the control unit 130 may determine the negative electrode participation start point of the battery as ni1 and determine the negative electrode participation end point as nf8.

Preferably, the profile determining unit 120 may be configured to generate a plurality of adjustment positive electrode profiles Rp1' to Rp8' such that the end point of the adjustment positive electrode profile Rp' for the previous section is the same as the start point of the adjustment positive electrode profile Rp' for the next section. Likewise, the profile determining unit 120 may be configured to generate a plurality of adjustment negative electrode profiles Rn1' to Rn8' such that the end point of the adjustment negative electrode profile Rn' for the previous section is the same as the start point of the adjustment negative electrode profile Rn' for the next section.

Specifically, since the plurality of adjustment positive electrode profiles Rp1' to Rp8' are determined as the adjustment positive electrode profile Rp' of the battery as a whole, the plurality of adjustment positive electrode profiles Rp1' to Rp8' must be continuous. Likewise, since the plurality of adjustment negative electrode profiles Rn1' to Rn8' are determined as the adjustment negative electrode profile Rn' of the battery as a whole, the plurality of adjustment negative electrode profiles Rn1' to Rn8' must be continuous.

For example, in the embodiment of FIG. 11, the profile determining unit 120 may set the positive electrode participation start point pi2 of the second adjustment positive electrode profile Rp2' to be equal to the positive electrode participation end point pf1 of the first adjustment positive electrode profile Rp1' and then determine the positive electrode participation end point pf2 of the second adjustment positive electrode profile Rp2'. Likewise, the profile determining unit 120 may set the positive electrode participation start points pi3 to pi8 of the third to eighth adjustment positive electrode profiles Rp3' to Rp8' to respectively correspond to the positive electrode participation end points pf2 to pf7 of the second to seventh adjustment positive electrode profiles Rp2' to Rp7'.

In addition, in the embodiment of FIG. 11, the profile determining unit 120 may set the negative electrode participation start point ni2 of the second adjustment negative electrode profile Rn2' to be equal to the negative electrode participation end point nf1 of the first adjustment negative electrode profile Rn1' and then determine the negative electrode participation end point nf2 of the second adjustment negative electrode profile Rn2'. Likewise, the profile determining unit 120 may set the negative electrode participation start points ni3 to ni8 of the third to eighth adjustment negative electrode profiles Rn3' to Rn8' to respectively correspond to the negative electrode participation end points nf2 to nf7 of the second to seventh adjustment negative electrode profiles Rn2' to Rn7'.

Also, in the embodiment of FIG. 11, the control unit 130 may determine the positive electrode participation start point of the adjustment positive electrode profile Rp' for the battery as pi1, and the positive electrode participation end point as pf8. Additionally, the control unit 130 may determine the negative electrode participation start point of the adjustment negative electrode profile Rn' for the battery as ni1, and the negative electrode participation end point as nf8.

Since the battery management apparatus 100 according to an embodiment of the present disclosure determines the adjustment positive electrode profile and the adjustment negative electrode profile for each of the plurality of sections, the positive electrode degradation and the negative electrode degradation of the battery for each of the plurality of sections may be determined. That is, the battery management apparatus 100 has the advantage of being able to estimate the positive electrode degradation and negative electrode degradation for each detailed section, thereby deriving a diagnostic factor that can more accurately diagnose the state of the battery. Additionally, the battery management apparatus 100 has the advantage of being able to more accurately and precisely diagnose the state of the positive electrode and negative electrode of the battery through the derived diagnostic factor.

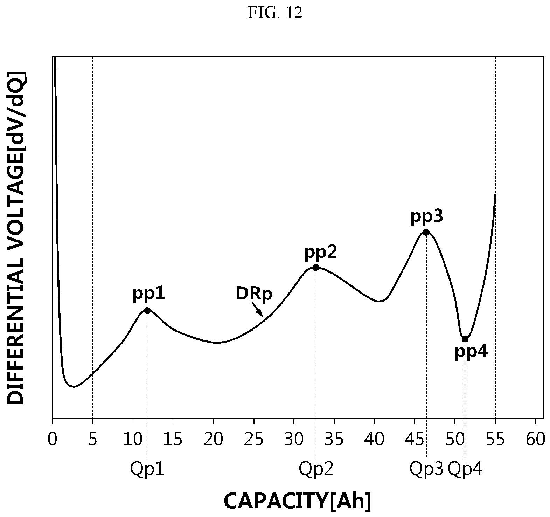

Hereinafter, with reference to FIGS. 12 to 15, a third embodiment in which the profile determining unit 120 adjusts the reference positive electrode profile Rp and the reference negative electrode profile Rn will be described in detail.

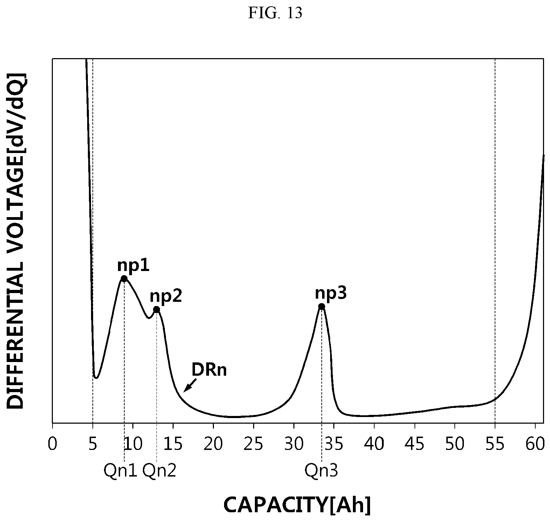

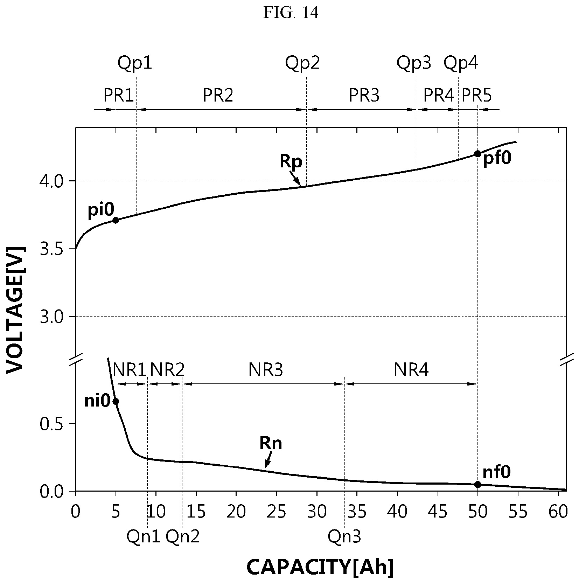

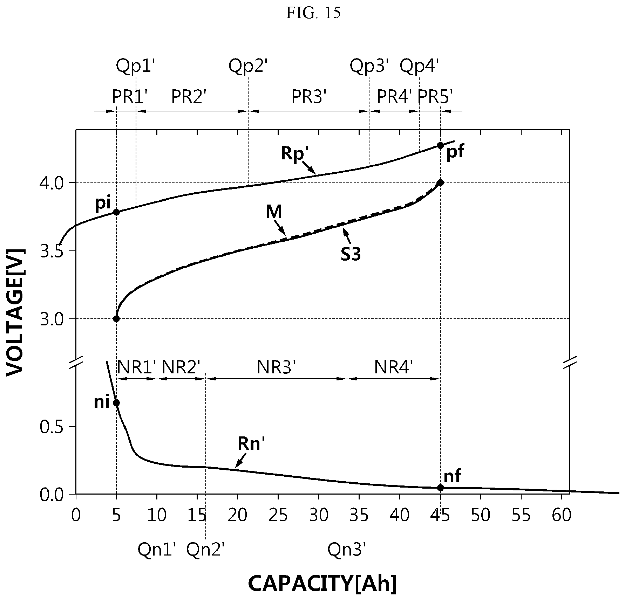

FIG. 12 is a diagram showing a positive electrode differential profile DRp according to an embodiment of the present disclosure. FIG. 13 is a diagram showing a negative electrode differential profile DRn according to an embodiment of the present disclosure. FIG. 14 is a diagram showing a reference positive electrode profile Rp and a reference negative electrode profile Rn according to an embodiment of the present disclosure. FIG. 15 is a diagram showing the measurement full-cell profile M and a third comparison full-cell profile S3 according to an embodiment of the present disclosure.

The profile obtaining unit 110 may be configured to obtain at least one of the positive electrode differential profile DRp corresponding to the reference positive electrode profile Rp and the negative electrode differential profile DRn corresponding to the reference negative electrode profile Rn as an electrode differential profile.

Specifically, the positive electrode differential profile DRp is a profile obtained by differentiating the reference positive electrode profile Rp with respect to capacity. The negative electrode differential profile DRn is a profile obtained by differentiating the reference negative electrode profile Rn with respect to capacity.

For example, in the embodiment of FIG. 12, the positive electrode differential profile DRp may be expressed as a two-dimensional X-Y graph with the X-axis set to capacity [Ah] and the Y-axis set to differential voltage [dV/dQ]. In the embodiment of FIG. 13, the negative electrode differential profile DRn may be expressed as a two-dimensional X-Y graph with the X-axis set to capacity [Ah] and the Y-axis set to differential voltage [dV/dQ].

For example, the profile obtaining unit 110 may directly receive the positive electrode differential profile DRp and the negative electrode differential profile DRn of the battery from the outside. That is, the profile obtaining unit 110 may receive information from the outside by wire and/or wirelessly. As another example, the profile obtaining unit 110 may generate a positive electrode differential profile DRp and a negative electrode differential profile DRn based on the reference positive electrode profile Rp and the reference negative electrode profile Rn.

The profile determining unit 120 may be configured to divide the corresponding reference electrode profile among the reference positive electrode profile Rp and the reference negative electrode profile Rn into a plurality of electrode sections based on at least one of the plurality of electrode peaks included in the electrode differential profile.

Specifically, the positive electrode differential profile DRp may include a plurality of positive electrode peaks, and the negative electrode differential profile DRn may include a plurality of negative electrode peaks.

In the embodiment of FIG. 12, the positive electrode differential profile DRp may include the first to fourth positive electrode peaks pp1, pp2, pp3, and pp4. Specifically, the positive electrode peak may include a peak corresponding to the maximum point of the positive electrode differential profile DRp. The positive electrode peak may include a peak corresponding to the minimum point with the largest capacity among the plurality of maximum points of the positive electrode differential profile DRp. The capacity of the first positive electrode peak pp1 is Qp1, the capacity of the second positive electrode peak pp2 is Qp2, the capacity of the third positive electrode peak pp3 is Qp3, and the capacity of the fourth positive electrode peak pp4 is Qp4.

In the embodiment of FIG. 13, the negative electrode differential profile DRn may include the first to third negative electrode peaks np1, np2, np3. Specifically, the negative electrode peak may include a peak corresponding to the maximum point of the negative electrode differential profile DRn. The capacity of the first negative electrode peak np1 is Qn1, the capacity of the second negative electrode peak np2 is Qn2, and the capacity of the third negative electrode peak np3 is Qn3.

In the embodiment of FIG. 14, the profile determining unit 120 may divide the reference positive electrode profile Rp into first to fifth positive electrode sections PR1 to PR5. The first positive electrode section PR1 is the capacity section of 5 [Ah] to Qp1, and the second positive electrode section PR2 is the capacity section of Qp1 to Qp2. The third positive electrode section PR3 is the capacity section of Qp2 to Qp3, the fourth positive electrode section PR4 is the capacity section of Qp3 to Qp4, and the fifth positive electrode section PR5 is the capacity section of Qp4 to 50 [Ah].

Additionally, in the profile determining unit 120, the reference negative electrode profile Rn may be divided into first to fourth negative electrode sections NR1 to NR4. The first negative electrode section NR1 is the capacity section of 5 [Ah] to Qn1, and the second negative electrode section NR2 is the capacity section of Qn1 to Qn2. The third negative electrode section NR3 is the capacity section of Qn2 to Qn3, and the fourth negative electrode section NR4 is the capacity section of Qn3 to 50 [Ah].

The profile determining unit 120 may be configured to adjust the reference positive electrode profile Rp and the reference negative electrode profile Rn to correspond to the measurement full-cell profile M while adjusting each of the plurality of electrode sections.

Specifically, the profile determining unit 120 may be configured to independently adjust each of the plurality of electrode sections. That is, the profile determining unit 120 may determine the adjustment positive electrode profile Rp' and the adjustment negative electrode profile Rn' corresponding to the measurement full-cell profile M by independently adjusting the change rate of each of the plurality of electrode sections.

The adjustment positive electrode profile Rp' may be divided into a plurality of adjustment positive electrode sections PR1' to PR5', and the adjustment negative electrode profile Rn' may be divided into a plurality of adjustment negative electrode sections NR1' to NR4'. Each of the plurality of adjustment positive electrode sections PR1' to PR5' is obtained by changing each of the plurality of positive electrode sections PR1 to PR5 of the reference positive electrode profile Rp, and the plurality of adjustment negative electrode section NR1' to NR4' is obtained by changing each of the plurality of negative electrode sections NR1 to NR4 of the reference negative electrode profile Rn.

For example, in the embodiment of FIG. 15, the adjustment positive electrode profile Rp' may be divided into the first to fifth adjustment positive electrode sections PR1' to PR5', and each of the first to fifth adjustment positive electrode sections PR1' to PR5' corresponds to each of the first to fifth positive electrode sections PR1 to PR5 of the reference positive electrode profile Rp. The first adjustment positive electrode section PR1' is a section where the first positive electrode section PR1 is changed, and the second adjustment positive electrode section PR2' is a section where the second positive electrode section PR2 is changed. The third adjustment positive electrode section PR3' is a section where the third positive electrode section PR3 is changed, the fourth adjustment positive electrode section PR4' is a section where the fourth positive electrode section PR4 is changed, and the fifth adjustment positive electrode section PR5' is a section where the fifth positive electrode section PR5 is changed. The control unit 130 may determine the positive electrode participation start point pi and the positive electrode participation end point pf of the adjustment positive electrode profile Rp'. Additionally, the control unit 130 may determine the positive electrode change rate ps1 to ps5 for each of the first to fifth adjustment positive electrode sections RP1' to PR5'. For example, the control unit 130 may determine the ratio of the first adjustment positive electrode section PR1' to the first positive electrode section PR1 as the positive electrode change rate ps1 for the first adjustment positive electrode section PR1'. That is, the control unit 130 may determine the positive electrode change rates ps1 to ps5 for the plurality of adjustment positive electrode sections RP1' to PR5' by calculating the change rate of the adjustment positive electrode sections RP1' to PR5' with respect to the positive electrode sections PR1 to PR5. Likewise, the control unit 130 may determine the positive electrode change rates ps2 to ps5 for the second to fifth adjustment positive electrode sections PR2' to PR5'.

Likewise, in the embodiment of FIG. 15, the adjustment negative electrode profile Rn' may be divided into first to fourth adjustment negative electrode sections NR1' to NR4', and each of the first to fourth adjustment negative electrode sections NR1' to NR4' corresponds to each of the first to fourth negative electrode sections NR1 to NR4 of the reference negative electrode profile Rn. The first adjustment negative electrode section NR1' is a section where the first negative electrode section NR1 is changed, and the second adjustment negative electrode section NR2' is a section where the second negative electrode section NR2 is changed. The third adjustment negative electrode section NR3' is a section where the third negative electrode section NR3 is changed, and the fourth adjustment negative electrode section NR4' is a section where the fourth negative electrode section NR4 is changed. The control unit 130 may determine the negative electrode participation start point ni and the negative electrode participation end point nf of the adjustment negative electrode profile Rn'. Additionally, the control unit 130 may determine the negative electrode change rate ns1 to ns4 for each of the first to fourth adjustment negative electrode sections NR1' to NR4'. For example, the control unit 130 may determine the ratio of the first adjustment negative electrode section NR1' to the first negative electrode section NR1 as the negative electrode change rate ns1 to the first adjustment negative electrode section NR1'. That is, the control unit 130 may determine the negative electrode change rates to the plurality of adjustment negative electrode sections NR1' to NR4' by calculating the change rate of the adjustment negative electrode sections NR1' to NR4' to the negative electrode sections NR1 to NR4. Likewise, the control unit 130 may determine the negative electrode change rates ns2 to ns4 for the second to fourth adjustment negative electrode sections NR2' to NR4'.

The profile determining unit 120 may determine the third comparison full-cell profile S3 corresponding to the measurement full-cell profile M based on the adjustment positive electrode profile Rp' and the adjustment negative electrode profile Rn'. In the embodiment of FIG. 15, the control unit 130 may determine the positive electrode participation start point of the battery as pi and the positive electrode participation end point as pf. Additionally, the control unit 130 may determine the negative electrode participation start point of the battery as ni and the negative electrode participation end point as nf.

In other words, if the positive electrode differential profile DRp is included in the electrode differential profile, the profile determining unit 120 may be configured to divide the reference positive electrode profile Rp into a plurality of positive electrode sections based on at least one of the plurality of positive electrode peaks included in the positive electrode differential profile DRp. In addition, if the negative electrode differential profile DRn is included in the electrode differential profile, the profile determining unit 120 may be configured to divide the reference negative electrode profile Rn into a plurality of negative electrode sections based on at least one of the plurality of negative electrode peaks included in the negative electrode differential profile DRn. In the above, with reference to FIGS. 12 to 14, an embodiment in which both the positive electrode differential profile DRp and the negative electrode differential profile DRn are included in the electrode differential profile, the reference positive electrode profile Rp is divided into a plurality of positive electrode sections and the reference negative electrode profile Rn is divided into a plurality of negative electrode sections has been described. However, depending on the embodiment, the positive electrode differential profile DRp or the negative electrode differential profile DRn may be included in the electrode differential profile.

The battery management apparatus 100 according to an embodiment of the present disclosure may determine an adjustment positive electrode profile and an adjustment negative electrode profile by adjusting the plurality of positive electrode sections and/or the plurality of negative electrode sections, respectively. In other words, the battery management apparatus 100 has the advantage of being able to determine detailed diagnostic factors for the battery. Therefore, based on these diagnostic factors, the state of the battery may be diagnosed in more detail and accurately.

The battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the configuration included in the conventional BMS. For example, the profile obtaining unit 110, the profile determining unit 120, the control unit 130 and the storage unit 140 may be implemented as components of the BMS.

The battery management apparatus 100 according to the present disclosure may be provided in a battery pack. That is, the battery pack according to the present disclosure may include the above-described battery management apparatus 100 and one or more battery cells. In addition, the battery pack may further include electrical equipment (relays, fuses, etc.) and a case.

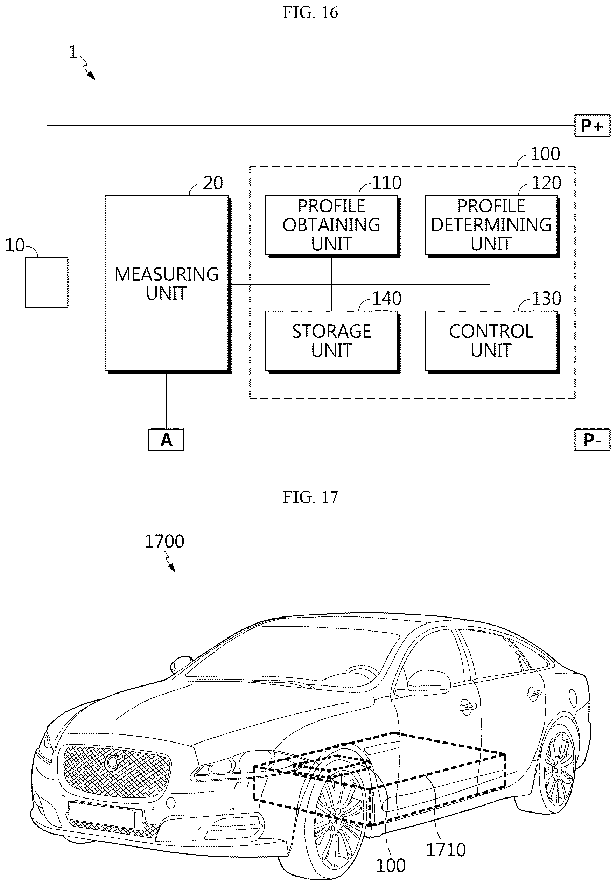

FIG. 16 is a diagram showing an exemplary configuration of a battery pack 1 according to another embodiment of the present disclosure.

The positive electrode terminal of the battery 10 may be connected to the positive electrode terminal P+ of the battery pack 1, and the negative electrode terminal of the battery 10 may be connected to the negative electrode terminal P- of the battery pack 1.

The measuring unit 20 may be connected to the positive electrode terminal and negative electrode terminal of the battery 10. Additionally, the measuring unit 20 may measure the voltage of the battery 10 by measuring the positive electrode potential and negative electrode potential of the battery 10 and calculating the difference between the positive electrode potential and negative electrode potential.

In addition, the measuring unit 20 may be connected to an ampere meter A. For example, the ampere meter A may be an ammeter or a shunt resistor capable of measuring the charging current and the discharging current of the battery 10. The measuring unit 20 may calculate the charge amount by measuring the charging current of the battery 10 using the ampere meter A. Also, the measuring unit 20 may calculate the discharge amount by measuring the discharge current of the battery 10 using the ampere meter A.

For example, the information about the voltage and capacity of the battery 10 measured by the measuring unit 20 may be transmitted to the profile obtaining unit 110. Additionally, the profile obtaining unit 110 may directly generate a measurement full-cell profile M based on the received information about the voltage and capacity.

As another example, the information about the voltage and capacity of the battery 10 measured by the measuring unit 20 may be stored in the storage unit 140. When the charging or discharging of the battery 10 is completed, the profile obtaining unit 110 may access the storage unit 140 to obtain the measurement full-cell profile M.

As still another example, the measuring unit 20 may directly generate a measurement full-cell profile M based on the information about the measured voltage and capacity of the battery 10. In this case, the generated measurement full-cell profile M may be transmitted to the profile obtaining unit 110 and also be stored in the storage unit 140.

A charge/discharge device or load may be connected to the positive electrode terminal P+ and negative electrode terminal P- of the battery pack 1.

FIG. 17 is a diagram schematically showing a vehicle 1700 according to still another embodiment of the present disclosure.

Referring to FIG. 17, the battery pack according to an embodiment of the present disclosure may be included in a vehicle 1700 such as an electric vehicle (EV) or a hybrid vehicle (HV). Additionally, the battery pack 1710 may drive the vehicle 1700 by supplying power to the motor through an inverter provided in the vehicle 1700. Here, the battery pack 1710 may include the battery management apparatus 100. That is, the vehicle 1700 may include the battery management apparatus 100. In this case, the battery management apparatus 100 may be an on-board device included in the vehicle 1700.

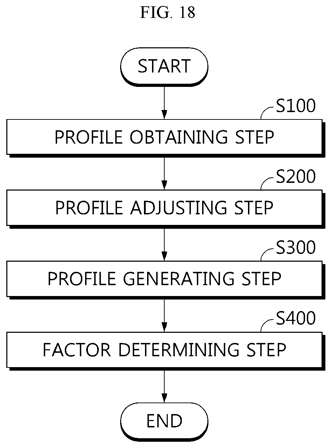

FIG. 18 is a diagram schematically showing a battery management method according to still another embodiment of the present disclosure.

Referring to FIG. 18, the battery management method may include a profile obtaining step (S100), a profile adjusting step (S200), a profile generating step (S300), and a factor determining step (S400).

Preferably, each step of the battery management method may be performed by the battery management apparatus 100. Hereinafter, for convenience of explanation, contents overlapping with the previously described contents will be omitted or briefly described.

The profile obtaining step (S100) is a step of obtaining a measurement full-cell profile M representing the corresponding relationship between voltage and capacity of a battery, and may be performed by the profile obtaining unit 110.

For example, the profile obtaining unit 110 may directly receive the measurement full-cell profile M of the battery from the outside. That is, the profile obtaining unit 110 may obtain the measurement full-cell profile M by receiving the measurement full-cell profile M by being connected to the outside by wire and/or wirelessly.

As another example, the profile obtaining unit 110 may receive battery information about the voltage and capacity of the battery. Also, the profile obtaining unit 110 may obtain the measurement full-cell profile M by generating the measurement full-cell profile M based on the received battery information.

The profile adjusting step (S200) is a step of dividing the measurement full-cell profile M into a plurality of sections according to a predetermined criterion, and adjusting a preset reference positive electrode profile Rp and a reference negative electrode profile Rn to correspond to the measurement full-cell profile M based on a weight for each of the plurality of sections, and may be performed by the profile determining unit 120.

For example, if the measurement full-cell profile M is divided into a plurality of sections, the profile determining unit 120 may determine the target section of the measurement full-cell profile M, and adjust the reference positive electrode profile Rp and the reference negative electrode profile Rn so that the error rate in the target section is lowest.

The profile generating step (S300) is a step of generating an adjustment positive electrode profile Rp' and an adjustment negative electrode profile Rn' according to the adjustment result, and may be performed by the profile determining unit 120.

For example, in the embodiment of FIG. 9, the profile determining unit 120 may determine the adjustment positive electrode profile Rp' and the adjustment negative electrode profile Rn' that have the lowest error rate for the determined target section. The first comparison full-cell profile S1 may be determined based on the adjustment positive electrode profile Rp' and the adjustment negative electrode profile Rn'.

The factor determining step (S400) is a step of determining a positive electrode factor for the battery in the adjustment positive electrode profile Rp' and determining a negative electrode factor for the battery in the adjustment negative electrode profile Rn', and may be performed by the control unit 130.

Specifically, the control unit 130 may determine a positive electrode participation start point, a positive electrode participation end point, and a positive electrode change rate in the adjustment positive electrode profile Rp', and determine a negative electrode participation start point, a negative electrode participation end point, and a negative electrode change rate in the adjustment negative electrode profile Rn'.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, the detailed description and specific examples, while indicating preferred embodiments of the disclosure, are given by way of illustration only, since various changes and modifications within the scope of the disclosure will become apparent to those skilled in the art from this detailed description.

Additionally, many modifications and changes may be made to the present disclosure described hereinabove by those skilled in the art without departing from the technical aspects of the present disclosure, and the present disclosure is not limited to the above-described embodiments and the accompanying drawings.

### (Explanation of reference signs)

1: battery pack
10: battery
20: measuring unit
100: battery management apparatus
110: profile obtaining unit
120: profile determining unit
130: control unit
140: storage unit
1700: vehicle
1710: battery pack

## Claims

1. A battery management apparatus (100), comprising:
a profile obtaining unit (110) configured to obtain a measurement full-cell profile representing the corresponding relationship between voltage and capacity of a battery (10);
a profile determining unit (120) configured to divide the measurement full-cell profile into a plurality of sections according to a predetermined criterion, adjust a preset reference positive electrode profile and a reference negative electrode profile to correspond to the measurement full-cell profile based on a weight for each of the plurality of sections, and generate an adjustment positive electrode profile and an adjustment negative electrode profile according to the adjustment result; and
a control unit (130) configured to determine a diagnostic factor for the battery (10) from at least one of the adjustment positive electrode profile and the adjustment negative electrode profile.

2. The battery management apparatus (100) according to claim 1,
wherein the profile obtaining unit (110) is configured to further obtain a full-cell differential profile corresponding to the measurement full-cell profile and representing the corresponding relationship between capacity and differential voltage, and
wherein the profile determining unit (120) is configured to divide the measurement full-cell profile into the plurality of sections based on at least one of a plurality of peaks included in the full-cell differential profile.

3. The battery management apparatus (100) according to claim 2,
wherein the profile determining unit (120) is configured to divide the measurement full-cell profile into the plurality of sections based on a plurality of reference peaks included in the full-cell differential profile.

4. The battery management apparatus (100) according to claim 2,
wherein the profile determining unit (120) is configured to set a weight for each of the plurality of sections and adjust the reference positive electrode profile and the reference negative electrode profile to correspond to the measurement full-cell profile based on the weight.

5. The battery management apparatus (100) according to claim 4,
wherein the profile determining unit (120) is configured to set a weight for a target section containing at least one of a plurality of target peaks included in the full-cell differential profile to be larger than weights for the remaining sections.

6. The battery management apparatus (100) according to claim 4,
wherein the profile determining unit (120) is configured to generate a comparison full-cell profile based on the adjustment positive electrode profile and the adjustment negative electrode profile, and adjust the reference positive electrode profile and the reference negative electrode profile so that a section where the set weight is larger has a lower error rate between the comparison full-cell profile and the measurement full-cell profile.

7. The battery management apparatus (100) according to claim 1,
wherein the control unit (130) is configured to determine a positive electrode factor included in the diagnostic factor based on the adjustment positive electrode profile and determine a negative electrode factor included in the diagnostic factor based on the adjustment negative electrode profile.

8. A battery pack (1710), comprising the battery management apparatus (100) according to any one of claims 1 to 7.

9. A vehicle (1700), comprising the battery management apparatus (100) according to any one of claims 1 to 7.

10. A battery management method performed by a battery management apparatus (100), the battery management method comprising:
a profile obtaining step of obtaining a measurement full-cell profile representing the corresponding relationship between voltage and capacity of a battery (10);
a profile adjusting step of dividing the measurement full-cell profile into a plurality of sections according to a predetermined criterion and adjusting a preset reference positive electrode profile and a reference negative electrode profile to correspond to the measurement full-cell profile based on a weight for each of the plurality of sections;
a profile generating step of generating an adjustment positive electrode profile and an adjustment negative electrode profile according to the adjustment result; and
a factor determining step of determining a diagnostic factor for the battery (10) from at least one of the adjustment positive electrode profile and the adjustment negative electrode profile.

## Patentansprüche

1. Batterieverwaltungsvorrichtung (100), umfassend:
eine Profilerhaltungseinheit (110), die konfiguriert ist, um ein Messvollzellenprofil zu erhalten, das die entsprechende Beziehung zwischen Spannung und Kapazität einer Batterie (10) darstellt;
eine Profilbestimmungseinheit (120), die konfiguriert ist, um das Messvollzellenprofil in eine Vielzahl von Abschnitten gemäß einem vorbestimmten Kriterium zu unterteilen, ein voreingestelltes positives Referenzelektrodenprofil und ein negatives Referenzelektrodenprofil anzupassen, um dem Messvollzellenprofil zu entsprechen, basierend auf einer Gewichtung für jeden der Vielzahl von Abschnitten, und ein positives Anpassungselektrodenprofil und ein negatives Anpassungselektrodenprofil gemäß dem Anpassungsergebnis zu erzeugen; und
eine Steuereinheit (130), die konfiguriert ist, um einen Diagnosefaktor für die Batterie (10) aus mindestens einem des positiven Anpassungselektrodenprofils und des negativen Anpassungselektrodenprofils zu bestimmen.

2. Batterieverwaltungsvorrichtung (100) nach Anspruch 1,
wobei die Profilerhaltungseinheit (110) konfiguriert ist, um ferner ein Vollzellendifferenzprofil zu erhalten, das dem Messvollzellenprofil entspricht und die entsprechende Beziehung zwischen Kapazität und Differenzspannung darstellt, und
wobei die Profilbestimmungseinheit (120) konfiguriert ist, um das Messvollzellenprofil in die Vielzahl von Abschnitten basierend auf mindestens einem einer Vielzahl von Spitzen zu unterteilen, die in dem Vollzellendifferenzprofil enthalten sind.

3. Batterieverwaltungsvorrichtung (100) nach Anspruch 2,
wobei die Profilbestimmungseinheit (120) konfiguriert ist, um das Messvollzellenprofil in die Vielzahl von Abschnitten basierend auf einer Vielzahl von Referenzspitzen zu unterteilen, die in dem Vollzellendifferenzprofil enthalten sind.

4. Batterieverwaltungsvorrichtung (100) nach Anspruch 2,
wobei die Profilbestimmungseinheit (120) konfiguriert ist, um eine Gewichtung für jeden der Vielzahl von Abschnitten einzustellen und das positive Referenzelektrodenprofil und das negative Referenzelektrodenprofil anzupassen, um dem Messvollzellenprofil basierend auf der Gewichtung zu entsprechen.

5. Batterieverwaltungsvorrichtung (100) nach Anspruch 4,
wobei die Profilbestimmungseinheit (120) konfiguriert ist, um eine Gewichtung für einen Zielabschnitt einzustellen, der mindestens eine einer Vielzahl von Zielspitzen enthält, die in dem Vollzellendifferenzprofil enthalten sind, um größer als Gewichtungen für die verbleibenden Abschnitte zu sein.

6. Batterieverwaltungsvorrichtung (100) nach Anspruch 4,
wobei die Profilbestimmungseinheit (120) konfiguriert ist, um ein Vergleichsvollzellenprofil basierend auf dem positiven Anpassungselektrodenprofil und dem negativen Anpassungselektrodenprofil zu erzeugen, und das positive Referenzelektrodenprofil und das negative Referenzelektrodenprofil anzupassen, so dass ein Abschnitt, in dem die eingestellte Gewichtung größer ist, eine niedrigere Fehlerrate zwischen dem Vergleichsvollzellenprofil und dem Messvollzellenprofil aufweist.

7. Batterieverwaltungsvorrichtung (100) nach Anspruch 1,
wobei die Steuereinheit (130) konfiguriert ist, um einen positiven Elektrodenfaktor zu bestimmen, der in dem Diagnosefaktor enthalten ist, basierend auf dem positiven Anpassungselektrodenprofil, und einen negativen Elektrodenfaktor zu bestimmen, der in dem Diagnosefaktor enthalten ist, basierend auf dem negativen Anpassungselektrodenprofil.

8. Batteriepack (1710), umfassend die Batterieverwaltungsvorrichtung (100) nach einem der Ansprüche 1 bis 7.

9. Fahrzeug (1700), umfassend die Batterieverwaltungsvorrichtung (100) nach einem der Ansprüche 1 bis 7.

10. Batterieverwaltungsverfahren, das von einer Batterieverwaltungsvorrichtung (100) durchgeführt wird, wobei das Batterieverwaltungsverfahren umfasst:
einen Profilerhaltungsschritt des Erhaltens eines Messvollzellenprofils, das die entsprechende Beziehung zwischen Spannung und Kapazität einer Batterie (10) darstellt;
einen Profilanpassungsschritt des Unterteilens des Messvollzellenprofils in eine Vielzahl von Abschnitten gemäß einem vorbestimmten Kriterium und des Anpassens eines voreingestellten positiven Referenzelektrodenprofils und eines negativen Referenzelektrodenprofils, um dem Messvollzellenprofil zu entsprechen, basierend auf einer Gewichtung für jeden der Vielzahl von Abschnitten;
einen Profilerzeugungsschritt des Erzeugens eines positiven Anpassungselektrodenprofils und eines negativen Anpassungselektrodenprofils gemäß dem Anpassungsergebnis; und
einen Faktorbestimmungsschritt des Bestimmens eines Diagnosefaktors für die Batterie (10) aus mindestens einem des positiven Anpassungselektrodenprofils und des negativen Anpassungselektrodenprofils.

## Revendications

1. Appareil de gestion de batterie (100), comprenant :
une unité d'obtention de profil (110) configurée pour obtenir un profil de cellule complète de mesure représentant la relation correspondante entre la tension et la capacité d'une batterie (10) ;
une unité de détermination de profil (120) configurée pour diviser le profil de cellule complète de mesure en une pluralité de sections en fonction d'un critère prédéterminé, ajuster un profil d'électrode positive de référence prédéfini et un profil d'électrode négative de référence pour correspondre au profil de cellule complète de mesure sur la base d'un poids pour chaque section de la pluralité de sections, et générer un profil d'électrode positive d'ajustement et un profil d'électrode négative d'ajustement en fonction du résultat d'ajustement ; et
une unité de commande (130) configurée pour déterminer un facteur de diagnostic pour la batterie (10) à partir d'au moins un profil parmi le profil d'électrode positive d'ajustement et le profil d'électrode négative d'ajustement.

2. Appareil de gestion de batterie (100) selon la revendication 1,
dans lequel l'unité d'obtention de profil (110) est configurée pour obtenir en outre un profil de différentiel de cellule complète correspondant au profil de cellule complète de mesure et représentant la relation correspondante entre la capacité et la tension différentielle, et
dans lequel l'unité de détermination de profil (120) est configurée pour diviser le profil de cellule complète de mesure en la pluralité de sections sur la base d'au moins une crête d'une pluralité de crêtes incluses dans le profil de différentiel de cellule complète.

3. Appareil de gestion de batterie (100) selon la revendication 2,
dans lequel l'unité de détermination de profil (120) est configurée pour diviser le profil de cellule complète de mesure en la pluralité de sections sur la base d'une pluralité de crêtes de référence incluses dans le profil de différentiel de cellule complète.

4. Appareil de gestion de batterie (100) selon la revendication 2,
dans lequel l'unité de détermination de profil (120) est configurée pour définir un poids pour chaque section de la pluralité de sections et ajuster le profil d'électrode positive de référence et le profil d'électrode négative de référence pour correspondre au profil de cellule complète de mesure sur la base du poids.

5. Appareil de gestion de batterie (100) selon la revendication 4,
dans lequel l'unité de détermination de profil (120) est configurée pour définir un poids pour une section cible contenant au moins une crête d'une pluralité de crêtes cibles incluses dans le profil de différentiel de cellule complète afin qu'il soit plus grand que les poids pour les sections restantes.

6. Appareil de gestion de batterie (100) selon la revendication 4,
dans lequel l'unité de détermination de profil (120) est configurée pour générer un profil de cellule complète de comparaison sur la base du profil d'électrode positive d'ajustement et du profil d'électrode négative d'ajustement, et ajuster le profil d'électrode positive de référence et le profil d'électrode négative de référence de sorte qu'une section où le poids défini est plus grand ait un taux d'erreur plus petit entre le profil de cellule complète de comparaison et le profil de cellule complète de mesure.

7. Appareil de gestion de batterie (100) selon la revendication 1,
dans lequel l'unité de commande (130) est configurée pour déterminer un facteur d'électrode positive inclus dans le facteur de diagnostic sur la base du profil d'électrode positive d'ajustement et déterminer un facteur d'électrode négative inclus dans le facteur de diagnostic sur la base du profil d'électrode négative d'ajustement.

8. Bloc-batterie (1710), comprenant l'appareil de gestion de batterie (100) selon n'importe laquelle des revendications 1 à 7.

9. Véhicule (1700), comprenant l'appareil de gestion de batterie (100) selon n'importe laquelle des revendications 1 à 7.

10. Procédé de gestion de batterie réalisé par un appareil de gestion de batterie (100), le procédé de gestion de batterie comprenant :
une étape d'obtention de profil pour obtenit un profil de mesure de cellule complète représentant la relation correspondante entre la tension et la capacité d'une batterie (10) ;
une étape d'ajustement de profil pour diviser le profil de cellule complète de mesure en une pluralité de sections selon un critère prédéterminé et ajuster un profil d'électrode positive de référence prédéfini et un profil d'électrode négative de référence pour correspondre au profil de cellule complète de mesure sur la base d'un poids pour chaque section de la pluralité de sections ;
une étape de génération de profil pour générer un profil d'électrode positive d'ajustement et un profil d'électrode négative d'ajustement en fonction du résultat d'ajustement ; et
une étape de détermination de facteur pour déterminer un facteur de diagnostic pour la batterie (10) à partir d'au moins un profil parmi le profil d'électrode positive d'ajustement et le profil d'électrode négative d'ajustement.
